Europäisches Patentamt

European Patent Office

Office européen des brevets

(19)

(11) Publication number: **0 375 777**
**A1**

(12) **EUROPEAN PATENT APPLICATION**
**published in accordance with Art.**
**158(3) EPC**

(21) Application number: 88904668.6

(22) Date of filing: 06.06.88

(86) International application number:
PCT/JP88/00544

(87) International publication number:
WO 89/12319 (14.12.89 89/29)

(51) Int. Cl.5: **H01L 23/36, H01L 23/46**

(43) Date of publication of application:
04.07.90 Bulletin 90/27

(84) Designated Contracting States:
**DE FR GB NL SE**

(71) Applicant: **HITACHI, LTD.**
**6, Kanda Surugadai 4-chome**
**Chiyoda-ku Tokyo 101(JP)**

(72) Inventor: **MORIHARA, Atsushi**
**9-2-305, Aoba-cho**
**Katsuta-shi Ibaraki 312(JP)**
Inventor: **NAGANUMA, Yoshio**
**8-18, Kokubu-cho 3-chome**
**Hitachi-shi Ibaraki 316(JP)**
Inventor: **KOYAMA, Shuntaro**
**9-16, Hashikabe 1-chome**
**Katsuta-shi Ibaraki 312(JP)**
Inventor: **YAMADA, Kazuji**
**8-32, Moriyama-cho 3-chome**
**Hitachi-shi Ibaraki 316(JP)**

Inventor: **SOGA, Tasao**
**16-1, Higashikanesawa-cho 1-chome**
**Hitachi-shi Ibaraki 316(JP)**
Inventor: **ARAKAWA, Hideo**
**17-2, Kanesawa-cho 5-chome**
**Hitachi-shi Ibaraki 316(JP)**
Inventor: **NOGITA, Shunsuke**
**13-17, Mizuki-cho 2-chome**
**Hitachi-shi Ibaraki 316(JP)**
Inventor: **HISHINUMA, Yukio**
**8-3, Nishinarusawa-cho 4-chome**
**Hitachi-shi Ibaraki 316(JP)**
Inventor: **DAIKOKU, Takahiro**
**2892-15, Kashiwada-cho**
**Ushiku-shi Ibaraki 300-12(JP)**

(74) Representative: **Patentanwälte Beetz sen. -**
**Beetz jun. Timpe - Siegfried -**
**Schmitt-Fumian- Mayr**
**Steinsdorfstrasse 10**
**D-8000 München 22(DE)**

(54) SEMICONDUCTOR PACKAGING MODULE AND HEAT-CONDUCTING BLOCK STRUCTURE USED THEREFOR.

(57) A semiconductor packaging module for efficiently removing the heat generated from a plurality of semiconductor elements. The semiconductor packaging module is so designed that cooling water can enter inside a protrusion with a triangular cross section of the heat-conducting block and flow near the semiconductor elements that generate heat. Thus, efficient cooling is possible on the heat-conducting block structure and the semiconductor packaging module.

FIG. 1

Title of the Invention:

SEMICONDUCTOR-MOUNTED MODULE AND HEAT
CONDUCTIVE HOUSING STRUCTURE USED THEREFOR

Technical Field:

This invention relates to a semiconductor-mounted module for use in efficiently removing the heat occurring in a plurality of semiconductors or a plurality of integrated circuits of a high degree of integration, and a heat conductive housing structure used therefor.

Background Art:

In a large-sized computer available in recent years, which demands that it has a high processing speed, the degree of integration of circuits has increased to a high level, so that the quantity of heat occurring in one integrated circuit has greatly increased. Therefore, an excessive temperature rise in the integrated circuits, which is left out of consideration in a large-sized computer, causes apprehensions of troubles, and cooling integrated circuits has posed serious problems in the techniques for packaging semiconductors on a large-sized computer. In order to reduce the length of the electric lines for bringing the integrated circuit chips near by with one another, a method of mounting a plurality of integrated circuit chips in a micropackage has been developed.

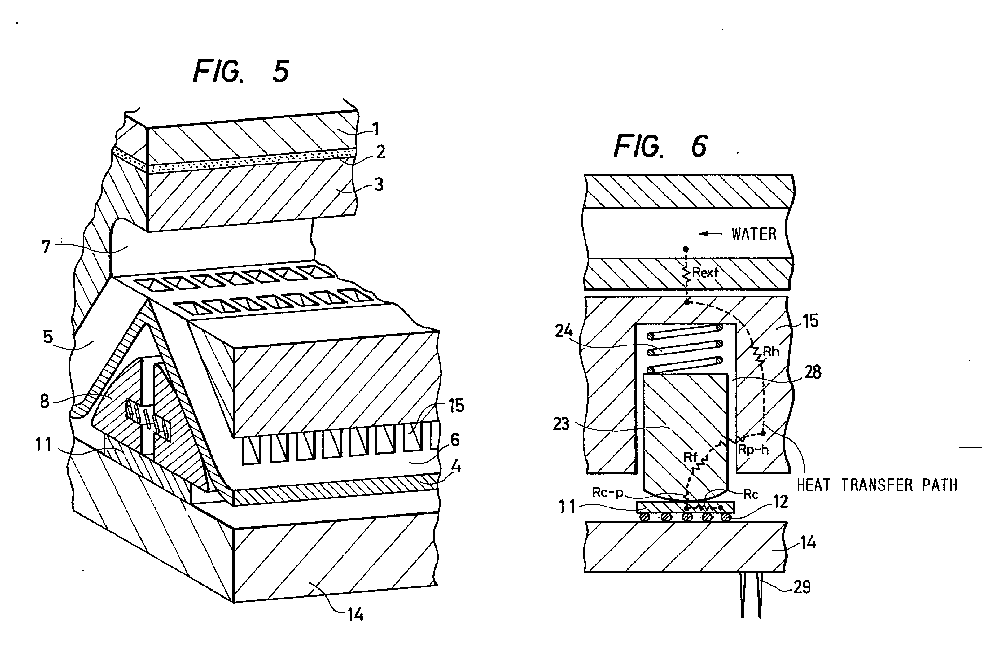

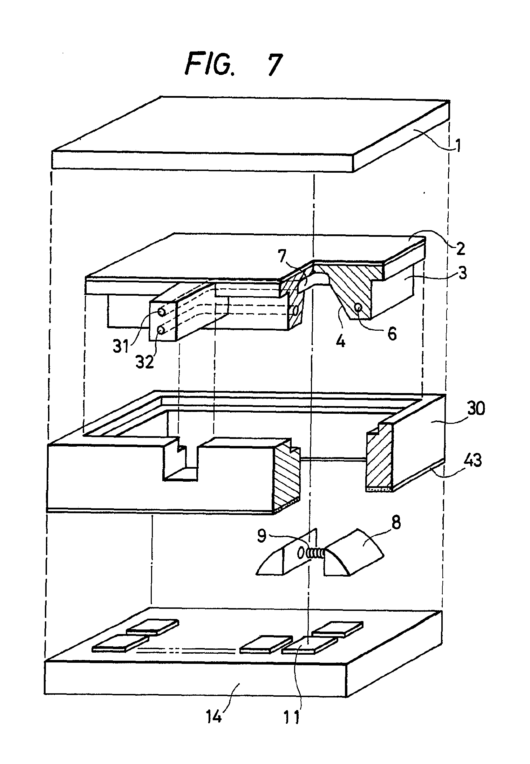

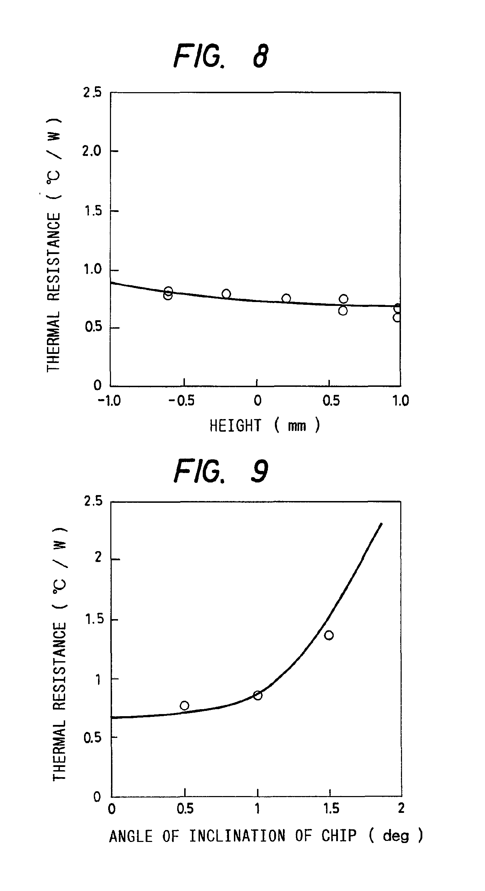

The first conventional techniques concerning a cooler for a large-sized electronic computer system will now be described with reference to Fig. 6.

Fig. 6 illustrates a gas-sealed type conduction cooling method disclosed in US Patent No. 5993123. A large scale integrated circuit (which will hereinafter be referred to as LSI) chip 11 is bonded with small solder balls 12 to a multilayer wiring substrate (which will hereinafter be referred to as substrate) 14 which consists of a plurality of conductor layers and insulating layers, and it is electrically connected to the lower side of the substrate 14 by connecting pins 29. A housing 15 is provided therein with a plurality of cylinders 28 in each of which a piston 23 for introducing heat from the upper surface of the LSI chip 11, and a spring 24 for applying a pressure to the piston 23 are inserted. The interface in which the substrate 14 and housing 15 contact each other is filled with helium having a high thermal conductivity.

The heat generated in the LSI chip 11 is transmitted along a path shown by a broken line in Fig. 6 to the piston 23 via the thermal resistance Rc in the interior of the LSI chip 11 and the thermal resistance Rc-p of the helium existing at a contact portion between the tip of the lower spherical surface of the piston 23 and the upper surface of the LSI chip. The heat is then transmitted to the housing 15 via the thermal resistance Rf of the piston 23 and the thermal resistance Rp-h of the helium existing in the space between the piston 23 and cylinder 28. The heat is then removed via the thermal resistance Rh of the housing 15 and the thermal resistance Rexf of the housing and a cooler 16 provided above the housing 15 and used with cooling water or a cooling medium flowing therethrough.

According to the second conventional techniques disclosed in Japanese Patent Laid-open No. 126853/1985, a plurality of fins are formed instead of using the piston 23 and cylinder 28. Owing to this structure, the thermal resistance of the helium layer is reduced.

The third conventional techniques in which heat conductive grease is used instead of helium, especially, between the piston 23 and cylinder 28 are disclosed in Japanese Patent Laid-open No. 15353/ 1986. In this example, which is not constructionally completed unless the heat conductive grease is used, a piston 23 is formed conically to increase the heat conductive surface area and a suitable level of contact pressure is applied to the opposed portions of the piston 23 and cylinder 28, so that excellent heat transfer characteristics can be obtained.

In these conventional techniques, improvements are made in many respects.

Each of the conventional cooler for computer systems consists basically of a heat transfer structure connecting a chip and a seal housing together, and a water cooling jacket provided to cool the heat transfer structure. The improvements made so as to reduce the thermal resistance are concentrated on the heat transfer structure. The points common to these conventional structures reside in that the distance between the cooling medium and chip is set too large due to the excessively complicated overall construction thereof, and this causes the thermal resistance of the structures to increase.

Since the water cooling jacket and seal housing in each of the prior art structures, the cooling water cannot be brought to a position closest to the chip, and it is difficult to cool a chip of not lower than several tens of watts.

Although various improvements are made in the prior art cooling structures, a structure having all kinds of performance demanded by a currently available large scale computer has not yet been proposed.

An object of the present invention is to provide a semiconductor-mounted module having excellent cooling characteristics, and a heat conductive housing structure used therefor.

Disclosure of the Invention:

A heat conductive block is formed to a triangular pole, and a heat conductive housing through which a cooling medium flows and an upper module are unitarily combined, the cooling water being introduced into the interior of the heat conductive housing. This arrangement enables the distance between the cooling water and a semiconductor element to be extremely reduced.

The present invention consists of three parts, i.e. (1) a heat conductive block, (2) a heat conductive housing and (3) a seal housing, and is characterized, especially, by the construction of the heat conductive housing opposed to a plurality of semiconductor elements. The construction of the present invention will now be described.

(1) Heat conductive block:

The heat conductive block slidably contacts both the heat conductive housing, which is cooled with a cooling medium, and a semiconductor element.

The heat conductive block has a triangular cross section extending perpendicularly to the surface thereof contacting the semiconductor element, as well as a semicylindrical surface, which has an axis perpendicular to this triangular cross section, at the portion of the disc which contacts the heat conductive housing. In this heat conductive block, a pair of block members are arranged in parallel with each other with their rear surfaces opposed to each other, and a resilient member is provided so as to keep the block members separated.

(2) Heat conductive housing:

The heat conductive housing has a space having a triangular cross section which extends along a plane perpendicular to the surfaces thereof contacting the heat conductive block, and which is substantially similar to the above-mentioned cross section of the heat conductive block.

The heat conductive block is moved in parallel with the surfaces, which the heat conductive block linearly contacts, of the heat conductive housing, or turned on the same contact surfaces, to absorb the vertically diagonal displacement of the semiconductor element.

Since the semicylindrical surface of the heat conductive block and the flat surfaces of the heat conductive housing are kept in linear contact with each other, the heat can be transmitted excellently.

The great characteristics of the present invention reside, especially, in the following. The lower surface of the heat conductive housing has an upwardly projecting cross-sectionally triangular portion contacting the heat conductive block in the above-mentioned cross section thereof. A flow passage into which a cooling medium is introduced directly is formed in the interior of this projecting portion, and cooling fins extending in parallel with the triangular cross section of the heat conductive block are provided on the upper side of the heat conductive plate the lower surface of which contacts the heat conductive block. The cooling medium flows from a supply passage into the spaces among these fins and toward a discharge passage. In an embodiment of the present invention, the cooling water flows from a supply passage formed at the top portion of the heat conductive housing toward a discharge passage formed at the bottom of the projecting portion of the lower surface thereof.

Owing to this arrangement, the semiconductor element and the cooling surface come close to each other to an ultimate level, so that the transmission of heat and the cooling of the semiconductor element can be effected excellently.

(3) Seal housing:

The heat conductive block is mounted on the semiconductor element set on a multilayer ceramic circuit board, and the heat conductive housing is provided over the block, all of the element and parts being sealed with the seal housing with a predetermined gas contained therein.

The sealing is done for the purpose of protecting the semiconductor element and reducing the contact thermal resistance of the heat conductive block and heat conductive housing and the contact thermal resistance of the heat conductive block and semiconductor element.

As described above, the present invention can be achieved by a semiconductor-mounted module having a heat conductive housing cooled with a cooling medium, and a heat conductive block contacting both a semiconductor element and heat conductive housing, the lower surface of the heat conductive housing having a cross-sectionally triangular projecting portion and contacting the heat conductive block at the inclined surface of the projecting portion thereof, a flow passage for a cooling medium being formed in the interior of the projecting portion.

The present invention can also be achieved by a semiconductor-mounted module, in which the lower surface of the heat conductive housing has a triangular projecting portion in its vertical cross section and contacts the heat conductive block at the inclined surface of the projecting portion thereof, a flow passage for a cooling medium being formed in the interior of the projecting portion.

The present invention can also be achieved by a semiconductor-mounted module, in which the lower surface of the heat conductive housing has a triangular projecting portion in its cross-section perpendicular to the upper surface of the semiconductor element and contacts the heat conductive block at the inclined surface of the projecting portion thereof, a flow passage for a cooling medium being formed in the interior of the projecting portion.

The present invention can also be achieved by a semiconductor-mounted module, in which the lower surface of the heat conductive housing has in its cross section perpendicular to the upper surface of the semiconductor element a projecting portion enclosed with at least two inclined surface portions contacting the heat conductive block, a flow passage for a cooling medium being formed in the interior of this projecting portion.

The present invention can also be achieved by a method of cooling a module, on which a plurality of semiconductor elements which generate a large quantity of heat are mounted, with a heat conductive housing, which has a projecting portion in which a flow passage for a cooling medium is formed, and a heat conductive block contacting both the semiconductor elements and heat conductive housing, a cooling medium being supplied to the portion of the flow passage which is close to the semiconductor elements, the cooling medium being discharged from the portion of the flow passage which is away from the semiconductor elements.

Since such construction is employed, the heat occurring in the semiconductor element is transmitted to the heat conductive housing through the heat conductive block.

The portion of the heat conductive housing which is closest to the semiconductor element is the most projecting portion thereof, the temperature of which becomes highest. At this highest-temperature portion, the lowest-temperature cooling medium which has just supplied exists. This enables the cooling of the semiconductor element to be done most effectively.

The portions to which the heat occurring in the semiconductor element is transmitted at the highest rate are the linearly contacting portions at which the distance between the heat conductive block and the heat conductive housing is the shortest. The portions of the interior of the heat conductive housing which correspond to these linearly contacting portions are provided with heat transmission promoting fins.

Owing to the above arrangement, the low-temperature cooling medium which has just supplied to the semiconductor-mounted module is sent to all the semiconductor elements, and the cooling medium which flows once to cool a semiconductor element does not flow to another to cool the same. Namely, all the semiconductor elements can be uniformly cooled.
Brief Description of the Drawings:

Fig. 1 is a sectional view of a first embodiment of the present invention:

Fig. 2 illustrates the principle of the present invention (the vertically diagonal displacement of a semiconductor element with respect to the axis thereto);

Fig. 3 illustrates the principle of the present invention (the vertical displacement of a semiconductor element);

Fig. 4 illustrates the principle of the present invention (the diagonal displacement of a semiconductor element in the direction parallel to the axis thereof);

Fig. 5 is a sectional view taken along the line A-A' in Fig. 1;

Fig. 6 is a sectional view of a prior art semiconductor-mounted module;

Fig. 7 is a perspective view showing the construction of the first embodiment of the module according to the present invention;

Fig. 8 shows calculated values and actually measured values representing the performance of the present invention (the influence of the vertical displacement of a semiconductor element);

Fig. 9 shows calculated values and actually measured values representing the performance of the present invention (the influence of the vertically diagonal displacement of a semiconductor element);

Fig. 10 shows calculated values and actually measured values representing the performance of the present invention (the influence of the sealing pressure);

Fig. 11 shows calculated values and actually measured values representing the performance of the present invention (the influence of the calorific power);

Fig. 12 shows calculated values and actually measured values representing the performance of the present invention (scatter in the module);

Fig. 13 is a sectional perspective of a second embodiment of the present invention;

Fig. 14 is a sectional view of a third embodiment of the present invention;

Fig. 15 is a longitudinal section of a fourth embodiment of the present invention; and

Fig. 16 is a lateral section of the fourth embodiment.

Best Modes for Embodying the Invention:

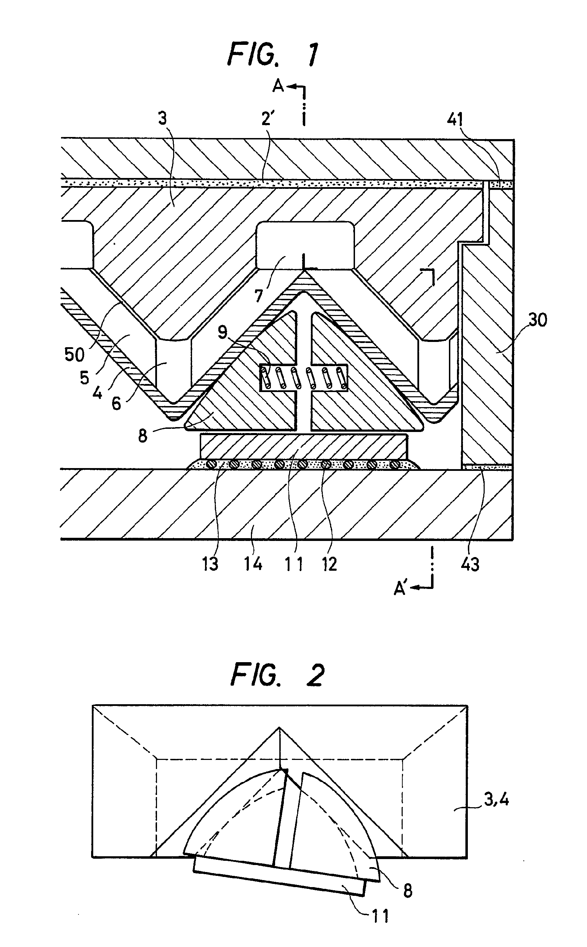

An embodiment of the present invention will now be described with reference to Figs. 1-5. Fig. is a cross-sectional view of a first embodiment of the present invention, and Figs. 2, 3 and 4 illustrate the displacement characteristics of the embodiment, Fig. 5 being a sectional view taken along the line A-A' in Fig. 1.

The construction of the parts of the embodiment of Fig. 1 will now be described. Hundreds of electric lines provided on the lower surface of a semiconductor chip 11 are connected by spherical solder balls 12 to a substrate board formed out of a ceramic material. The solder balls 12 are protected by a resin 13. The upper surface of the semiconductor chip 11 is in surface contact with a heat conductive block 8. The surfaces of the semiconductor chip 11 and heat conductive block 8 are processed so as to have a high thermal conductivity and a minimal frictional force.

The surface of the heat conductive block which is on the opposite side of the semiconductor chip 11 is inclined at an angle $\theta$, and processed so as to have a semicylindrical surface of a radius $r$. The angle $\theta$ and radius $r$ are important factors for determining the heat conduction characteristics and displacement characteristics of the heat conductive block 8. Although the heat conductive surface area (contact surface area of the heat conductive block 8 and heat conductive housing 3, 4) increases in proportion to the angle $\theta$, the distance between the heat conductive block 8 and semiconductor chip 11 increases to produce inadvantageous results. Let H and L equal the depth and width, respectively, of the heat conductive block 8. The total thermal resistance RT of an inclined portion (portion A-A') is expressed by the following

equation.

$$RT = \frac{\tan(\theta)}{kbH} + \frac{1}{hHL(1 + \tan(\theta)^2)^{1/2}}$$

wherein kb represents a heat transfer rate of the heat conductive block 8; $\underline{h}$ a heat transfer coefficient; a first member at the right side the thermal resistance of a contact surface; and a second member at the right side the thermal resistance of the heat conductive block 8. An optimum angle can be selected on the basis of the heat transfer rate of the heat conductive block 8 and the heat transfer coefficient of a contact surface and in accordance with this equation.

The radius $\underline{r}$ is determined depending upon the angle of inclination of the chip. Even when the chip is inclined at a maximum angle, it is necessary that the semicylindrical surface 2 engages the contact surface of the cooling portion of the heat conductive housing 1. Namely, the radius $\underline{r}$ is expressed by the formula,

$$r < \frac{L/2 \times \tan(\theta)}{\alpha}$$

wherein $\alpha$ is a maximum angle of inclination of the chip. The radius of the semicylindrical surface can be determined selectively in accordance with this formula.

The heat conductive block 8 is slidingly moved on the upper surface of the semiconductor chip 11. Accordingly, a resilient member 9 is provided as shown in Fig. 1, and the heat conductive block 8 contacts the side surfaces of the heat conductive housing 3, 4 and the upper surface of the semiconductor chip 11 at a pressure determined by a spring. The semicylindrical surface of the heat conductive block 8 and the flat surfaces of the heat conductive housing 3, 4 engage each other, i.e., they contact each other linearly. According to the present invention, the displacement of the chip in all directions including the vertical and diagonal direction is absorbed into these surfaces only. Although a system for absorbing such three-dimensional displacement of a semiconductor chip by a point contact structure has already been proposed, changing such a structure into a linear contact structure capable of obtaining better heat transfer characteristics constitutes the features of the embodiment of the present invention.

The principles of keeping the heat conductive block in linear contact with the heat conductive housing with respect to all kinds of displacement of a semiconductor chip will now be described with reference to Figs. 2, 3 and 4.

Fig. 2 shows a case where the semiconductor chip 11 is inclined in a direction perpendicular to the axis of the semicylindrical surface of the heat conductive block 8. In this case, the heat conductive block 8 is turned in a direction perpendicular to the axis of the semicylindrical surface of the heat conductive block 8 to keep the same block in linear contact with the heat conductive housing 3, 4.

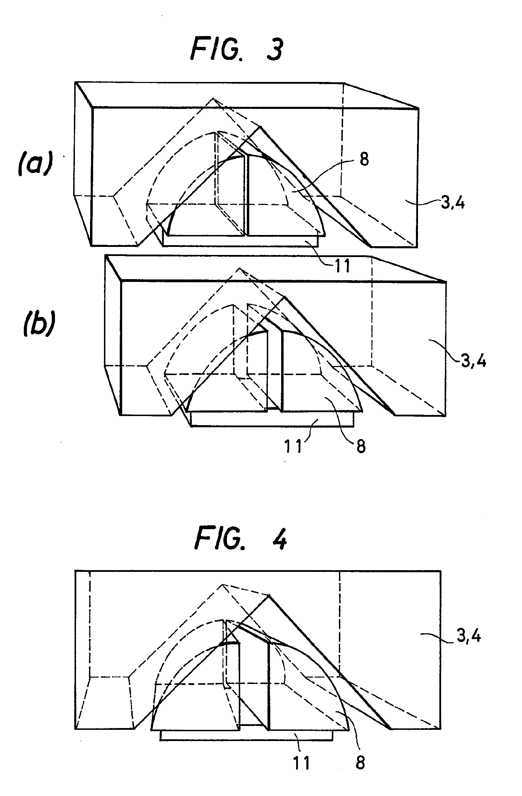

Fig. 3 shows a case where the semiconductor 11 is displaced vertically due to the flexure of the multilayer substrate 14. When the height of the semiconductor chip 11 is large (a), the heat conductive blocks 8 move toward each other to keep themselves in linear contact with the heat conductive housing. When the height of the semiconductor chip 11 is small (b), the heat conductive blocks 8 move away from each other to keep themselves in linear contact with the heat conductive housing.

A case where the semiconductor chip 11 is inclined in a direction perpendicular to the semicylindrical surface of the heat conductive block is shown in Fig. 4. Fig. 4 is a perspective taken along a cross section of the heat conductive block 8. When the front portion of the semiconductor chip 11 is inclined downward, the distance between the front portions of the heat conductive blocks 8 increases, and that between the rear portions thereof decreases.

As shown in these drawings, the heat conductive block 8 is turned on the contact surface of the heat conductive housing 3, 4 as the linearly contacting portions thereof are always kept parallel to each other, so that the transmission of the heat can be carried out excellently.

A detailed description of the heat conductive housing 3, 4 will now be given with reference to Figs. 1, 5 and 7.

The lower heat conductive housing 3 has a glossy surface on the lower side thereof so that this surface contacts the semicylindrical surface of the heat conductive block 8 as shown in Fig. 1, the housing 3 further having cooling fins 5 on the upper surface thereof. the upper heat conductive housing 3 is joined to the lower heat conductive housing 4 by a connecting member 50. The upper heat conductive housing 3 is sandwiched between the seal housings 1, 30 and fixed.

The details of the cooling fins 5 will now be given with reference to Fig. 5. Fig. 5 three-dimensionally shows the embodiment of Fig. 1 along a cross section A-A' in the same drawing. The cooling fins 5 are provided so as to extend in a direction perpendicular to the axis of the semicylindrical surface of the heat conductive block 8. A cooling medium supply passage 6 is provided in the portion of the lower heat conductive housing 4 which is the closest to the semiconductor chip 11, and a cooling medium discharge passage 7 on the opposite side of the supply passage 6.

The operation of the heat conductive housing will now be described. The heat occurring in the chip 11 is transmitted to the heat conductive housing through the heat conductive block 8.

The portion of the heat conductive housing which is closest to the chip 11 is the most projecting portion thereof, the temperature of which becomes the highest. In this embodiment, the cooling medium which has just supplied, and which has the lowest temperature, flows around this highest-temperature portion. Therefore, the cooling of the chip 11 can be done most effectively.

The portions in which the heat occurring in the chip 11 is transferred at the highest rate are the linearly contacting portions at which the distance between the heat conductive block 8 and heat conductive housing is the shortest. The heat conductive housing is provided at these linearly contacting portions with heat transfer promoting fins 15.

Owing to this arrangement, the low-temperature cooling medium which has just been supplied to the semiconductor-mounted module is sent to all the semiconductor chips 11, and teh cooling medium which has once cooled a semiconductor chip 11 does not flow to another to cool the same. This enables all the semiconductor chips 11 to be cooled uniformly.

A method of assembling this semiconductor-mounted module will now be described with reference to Fig. 7.

The inner portion of the upper surface of a seal housing (side walls) 30 is lowered, and the heat conductive housing 3, 4 has a projection engageable with the recessed portion thus formed of the seal housing 30. The upper heat conductive housing 3 is held between a seal housing (cover) 1 and seal housing (side walls) 30 fixed to a circuit board with a bonding member 43, and the seal housing (cover) 1 and upper heat conductive housing 3 are fixed closely to each other via a buffer member 2 (Fig. 7). The reason why the direct seal housing (cover) 1 and upper heat conductive housing 3 are not bonded to each other resides in that the direct seal housing (cover) 1 is formed out of a ceramic material so as to set the coefficient of thermal expansion thereof equal to that of the multilayer circuit board 14, which material is different from a metal (copper or aluminum) out of which the heat conductive housing 3, 4 is generally formed.

The multilayer circuit board 14 to which the cooling medium in the heat conductive housing is supplied is provided thereon with a plurality of semiconductor chips 11. The heat conductive block 8 is mounted on each semiconductor chip 11. The seal housing 30 is put over the resultant product from the upper side thereof as the positioning of the housing 30 is carried out. The seal housing 30 is bonded in a sealed state to the multilayer circuit board 14 with the bonding member 43 consisting of solder.

The cooling water the temperature of which is still low is supplied from a cooling water supply port 32. The cooling water supplied from the supply port 32 flows under the heat conductive housing and is sent into the water passage 6. The cooling water supplied to the water passage 6 absorbs the heat transmitted from the chip and flows into a return water passage 7. The cooling water entering the water passage 7 flows to the outside of the system through a cooling water discharge port 31.

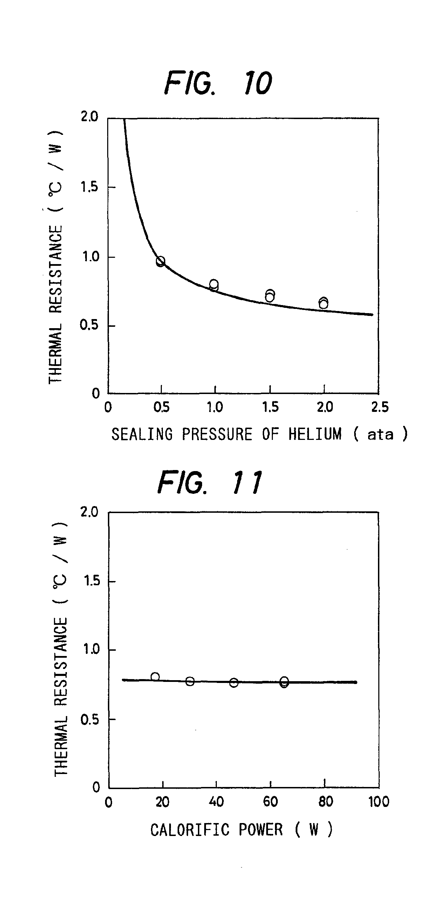

The calculated results and actually measured results of the performance of the first embodiment will now be described with reference to Figs. 8-12. Fig. 8 shows the influence of the variation of the height of the semiconductor chip 11 due to the flexure of the substrate upon the thermal resistance of the heat conductive block and housing and chip. A solid line represents calculated values, and what are plotted actually measured values. Fig. 9 shows variation of the thermal resistance of the heat conductive block and housing and semiconductor chip 11 in a case where the chip is inclined. These graphs show that, in any of these cases, the heat conductive block and housing are sufficiently kept in linear contact with each other with the thermal resistance of these parts and chip kept and low and stable even when the chip is displaced to a certain extent. Fig. 10 shows the results in a case where the sealing pressure of helium is varied. When the sealing pressure of helium is increased, a temperature rise is minimized. Consequently, the contact resistance becomes low, and the total thermal resistance lowers. Fig. 11 shows the results in a case where the calorific power of the semiconductor chip varies. This graph shows that the thermal resistance is kept substantially constant even when the calorific power varies, and that the semiconductor chip can be cooled sufficiently even when the integration of the circuits in a large-sized computer has advanced in the future.

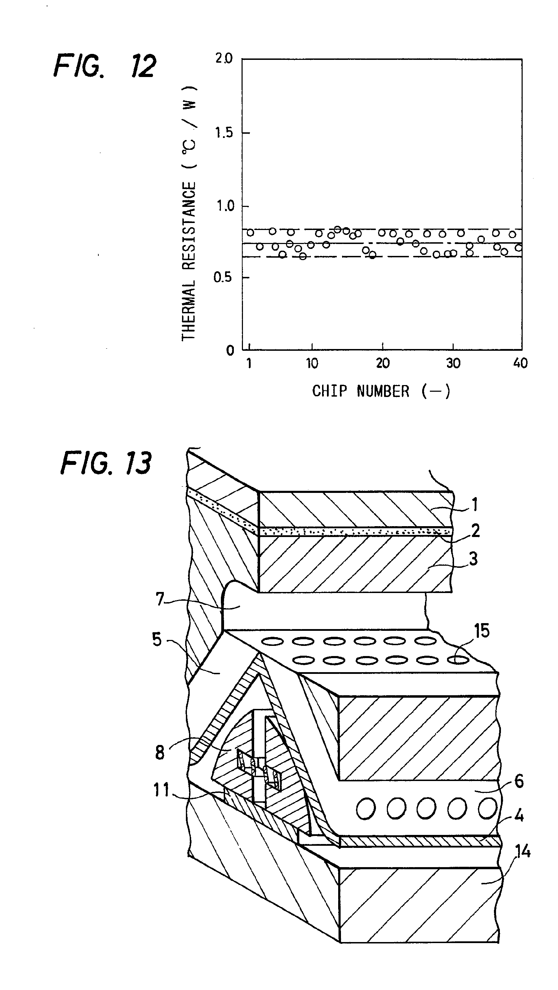

Fig. 12 shows the results of actual measurement of the thermal resistance of the semiconductor chips 11 in a case where the present invention is practiced by using a module in which 49 semiconductor chips 11 are arranged. The thermal resistance of each of the semiconductor chips 11 is kept low and stable.

Fig. 13 illustrates a second embodiment of the present invention. In this embodiment, small-diameter passages 15 are provided instead of the cooling fins 5 to improve the cooling performance. The effect peculiar to the present invention resides in its capability of improving the machinability of materials.

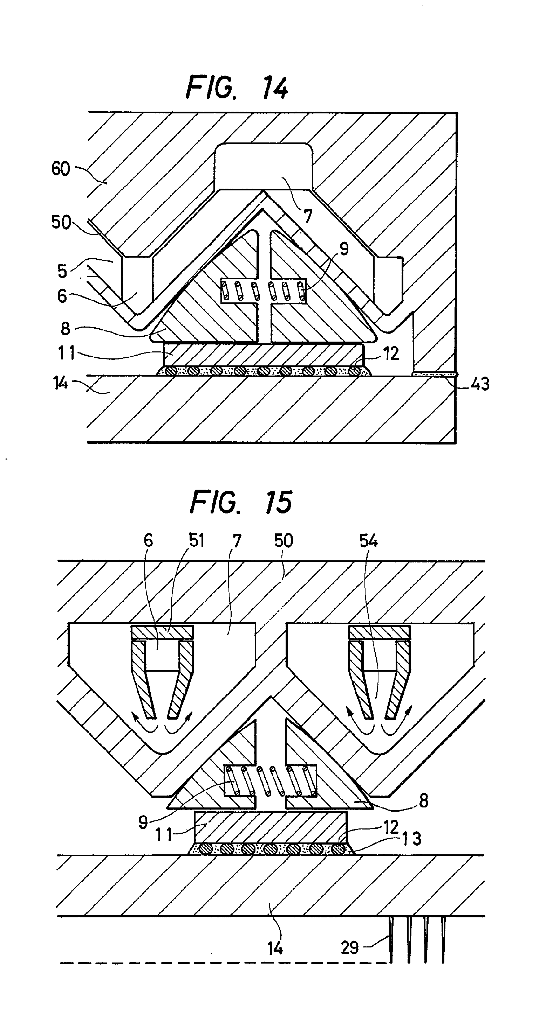

Some modes of second embodiment which can be made when the development of materials has advanced in the future are shown in Figs. 13 and 14. The differences between the second embodiment and first embodiment are as follows. In the first embodiment, it is necessary that the heat conductive housing 3, 4 be formed out of a metal. It is considered that, in the future, parts of a complicated shape like fins will become able to be manufactured out of a material of a low expansion coefficient, such as a ceramic material. In such a case, a structure in which the heat conductive housing 3, 4 and seal members 1, 30 are integrally formed can be obtained. In the embodiment of Fig. 14, a heat conductive seal member 60 is manufactured out of a ceramic material and capable of carrying out sealing and cooling operations at once. The effect peculiar to this embodiment is that the construction of the object product can be simplified since the heat conductive housing 3, 4 and seal members 1, 30 can be integrally formed.

The first and second embodiments employ a forcible convection cooling system in which fins are provided among which the cooling water is supplied to cool the semiconductor chip.

A third embodiment using a jet flow cooling system which has fins of a simplified shape, and which is capable of attaining excellent cooling performance, will now be described.

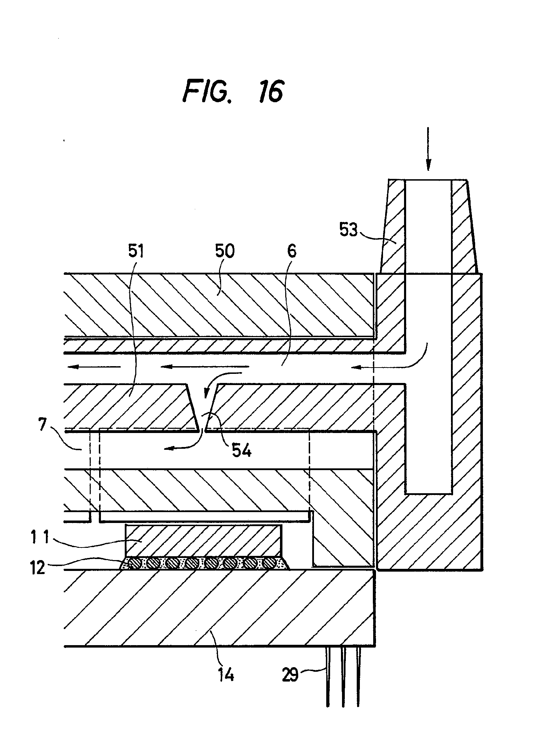

Figs. 15 and 16 show a third embodiment. Fig.

15 is cross-sectional view of the third embodiment.

A heat conductive block 50 has at the lower side thereof a glossy surface which is to contact the semicylindrical surface of a heat conductive block 8, in the same manner as in the first embodiment. However, unlike the first embodiment, the third embodiment is not provided with cooling fins 5 on the upper surface of the heat conductive housing 50. The heat conductive housing consists of a cooling water returning bore-carrying water passage 7, and a water supply pipe 6 provided in the water passage 7 and adapted to supply cooling water through a water supply pipe 51. The water supply passage 6 is provided with a cooling water ejecting nozzle 54.

The details of the heat conductive housing will now be given with reference to Fig. 16. A cooling water header 53 is provided at the inlet of the water supply passage 6, and cooling water is supplied uniformly to each water supply passage 6.

The operation of this heat conductive housing will now be described. The heat occurring in the chip 1 is transmitted to the heat conductive housing through the heat conductive block 8 in the same manner as in the first embodiment.

The portion of the heat conductive housing which is the closest to the chip 11 is the most projecting portion thereof, the temperature of which becomes highest. In the third embodiment, the lowest-temperature cooling medium which has just been supplied is ejected directly on this highest-temperature portion of the heat conductive housing. Accordingly, the cooling of the chip 11 can be done most effectively.

The portion to which the heat occurring in the chip 11 is transferred at the highest rate is a portion at which the distance between the heat conductive block 8 and heat conductive housing is the shortest, and at which the block and housing are in linear contact with each other. Since the cooling water which has just been supplied flows at a high speed to ·this portion of the heat conductive housing, the transmission of the heat can be carried out excellently.

Owing to this arrangement, the low-temperature cooling medium which has just been supplied to the semiconductor-mounted module is sent to all the semiconductor chips 11, and the cooling medium which has once cooled a semiconductor chip 11 does not flow to another to cool the same. This enables all the semiconductor chips 11 to be cooled uniformly.

According to the present invention described above, the cooling medium and a semiconductor chip can be brought ultimately close to each other by a simple structure, a sealed semiconductor-mounted module of a very simple construction having excellent performance can be provided at a low cost.

Claim:

1. A semiconductor-mounted module having a heat conductive housing cooled with a cooling medium, and a heat conductive block contacting both a semiconductor chip and said heat conductive housing, characterized in that a vertical cross section of said heat conductive housing has a triangular projecting portion, said heat conductive housing contacting said heat conductive block at the inclined surfaces thereof which define said triangular projecting portion, a flow passage for said cooling medium being formed in the interior of said projecting portion.

2. A semiconductor-mounted module having a heat conductive housing cooled with a cooling medium, and a heat conductive block slidably contacting both a semiconductor chip and said heat conductive housing, characterized in that a vertical cross section of said heat conductive housing has a triangular projecting portion, said heat conductive housing contacting said heat conductive block at the inclined surfaces thereof which define said triangular projecting portion, a flow passage for said cooling medium being formed in teh interior of said projecting portion.

3. A semiconductor-mounted module having a heat conductive housing cooled with a cooling medium, and a heat conductive block contacting both a semiconductor chip and said heat conductive housing, characterized in that said heat conductive block is divided via a resilient member, a vertical cross section of said heat conductive housing having a triangular projecting portion, said heat conductive housing contacting said heat conductive block at the inclined surfaces thereof which define said triangular projecting portion, a flow passage for said cooling medium being formed in the interior of said projecting portion.

4.    A semiconductor-mounted module having a heat conductive housing cooled with a cooling medium, and a heat conductive block slidably contacting both a semiconductor chip and said heat conductive housing, characterized in that said heat conductive block is divided via a resilient member, a vertical cross section of said heat conductive housing having a triangular projecting portion, said heat conductive housing contacting said heat conductive block at the inclined surfaces thereof which define said triangular projecting portion, a flow passage for said cooling medium being formed in the interior of said projecting portion.

5.    A semiconductor-mounted module having a heat conductive housing cooled with a cooling medium, and a heat conductive block slidably contacting both a semiconductor chip and said heat conductive housing, characterized in that said heat conductive block is divided via a resilient member, a vertical cross section of said heat conductive housing having a triangular projecting portion, said heat conductive housing linearly contacting said heat conductive block at the inclined surfaces thereof which define said triangular projecting portion, a flow passage for said cooling medium being formed in the interior of said projecting portion.

6.    A semiconductor-mounted module having a heat conductive housing cooled with a cooling medium, and a heat conductive block slidably contacting both a semiconductor chip and said heat conductive housing, characterized in that said heat conductive block is divided via a resilient member, said heat conductive housing having a projection portion, a cross section which is perpendicular to the upper surface of said semiconductor chip of said projecting portion being triangular, said heat conductive housing linearly contacting said heat conductive block at the inclined surfaces of said projecting portion thereof, a flow passage for said cooling medium being formed in the interior of said projecting portion.

7. A semiconductor-mounted module having a heat conductive housing cooled with a cooling medium, and a heat conductive block slidably contacting both a semicoductor chip and said heat conductive housing, characterized in that said heat conductive block consists of cross-sectionally fan-shaped columnar members arranged in an opposed state via a resilient member, said heat conductive housing having a projecting portion, a cross section which is perpendicular to the upper surface of said semiconductor chip of said projecting portion being triangular, said heat conductive housing linearly contacting said heat conductive block at the inclined surfaces of said projecting portion thereof, a flow passage for said cooling medium being formed in the interior of said projecting portion.

8. A semiconductor-mounted module having a heat conductive housing cooled with a cooling medium, and a heat conductive block slidably contacting both a semiconductor chip and said heat conductive housing, characterized in that said heat conductive block consists of columnar members each of which has two flat surfaces and one spherical surface, which columnar members are arranged in an opposed state via a resilient member, said heat conductive housing having a projecting portion, a cross section which is perpendicular to the upper surface of said semiconductor chip of said projecting portion being triangular, said heat conductive housing linearly contacting said heat conductive block at the inclined surfaces of said projecting portion thereof, a flow passage for said cooling medium being formed in the interior of said projecting portion.

9. A heat conductive housing structure for semiconductor-mounted modules, having a heat conductive housing cooled with a cooling medium, and a heat conductive block contacting both a semiconductor chip and said heat conductive housing, characterized in that a vertical cross section of said heat conductive housing has a triangular projecting portion, said heat conductive housing contacting said heat conductive block at the inclined surfaces thereof which define said triangular projecting portion, a flow passage for said cooling medium being formed in the interior of said projecting portion.

10. A heat conductive block structure for semiconductor-mounted modules, having a heat conductive housing cooled with a cooling medium, and a heat conductive block slidably contacting both a semiconductor chip and said heat conductive housing, characterized in that said heat conductive block consists of columnar members each of which has two flat surfaces and one spherical surface, which columnar members are arranged in an opposed state via a resilient member, said heat conductive block linearly contacting said heat conductive housing which has a projecting portion a vertical cross section of which is triangular, and which is provided in said projecting portion with a flow passage for said cooling medium.

11. A heat conductive block structure for semiconductor-mounted modules, having a heat conductive housing cooled with a cooling medium, and a heat conductive block slidably contacting both a semiconductor chip and said heat conductive housing, characterized in that said heat conductive block consists of cross-sectionally fan-shaped columnar members arranged in an opposed state via a resilient member, the spherical surfaces of said fan-shaped columnar members linearly contacting the inclined surfaces of said heat conductive housing which is provided therein with a flow passage for said cooling medium, and which has a triangular vertical cross section.

12. A semiconductor-mounted module having a heat conductive housing cooled with a cooling medium, and a heat conductive block slidably contacting both a semiconductor chip and said heat conductive housing, characterized in that said heat conductive housing has a projectiong portion defined by at least two inclined surfaces contacting said heat conductive block, a flow passage for said cooling medium being formed in the interior of said projecting portion.

13. A semiconductor-mounted module having a heat conductive housing cooled with a cooling medium, and a heat conductive block slidably conatcting both a semiconductor chip and said heat conductive housing, characterized in that said heat conductive housing has a projecting portion close to said semiconductor chip, a flow passage for said cooling medium being formed in the interior of said projecting portion.

14. A method of cooling a semiconductor-mounted module wherein a plurality of semiconductor chips generating a large quantity of heat are mounted, the cooling of said chips being done by the heat transmitting operations of a heat conductive housing and a plurality of heat conductive block members which contact both said chips and said heat conductive housings, comprising the step of supplying a cooling medium into a flow passage, which is formed in a projecting portion close to said semiconductor chips of said heat conductive housing, in such a manner that said cooling medium is discharged from a flow passage formed in the portion of said heat conductive housing which is away from said semiconductor chips.

15. A method of cooling a semiconductor-mounted module wherein a plurality of semiconductor chips generating a large quantity of heat are mounted, the cooling of said chips being done by the heat tarnsmitting operations of a heat conductive housing and a plurality of heat conductive block members which contact both said chips and said heat conductive housings, comprising the step of ejecting a cooling medium onto a projecting portion close to said semiconductor chips of said heat conductive housing.

16. A semiconductor-mounted module having a heat conductive housing cooled with a cooling medium, and a heat conductive block slidably contacting both a semiconductor chip and said heat conductive housing, characterized in that a vertical cross section of said heat conductive housing has a triangular projecting portion, said projecting portion contacting said heat conductive block at the inclined surfaces thereof, said projecting portion being provided therein with a cooling medium ejecting nozzle.

17. A semiconductor-mounted module having a plurality of semiconductor chips mounted on a multilayer circuit board, comprising a heat conductive housing which has a projecting portion the lower surface of which is triangular in vertical section, and which is provided in said projecting portion with a flow passage for a cooling medium, a heat conductive block contacting said semiconductor chips and said heat conductive housing and carrying out the transmission of heat therebetween, and a seal housing with which said semiconductor chips, said heat conductive block and said heat conductive housing are sealed.

18. A semiconductor-mounted module comprising a plurality of semiconductor chips, a heat conductive housing which has a projecting portion a vertical section of which is triangular, and which is provided in said projecting portion with a flow passage for a cooling medium, a heat conductive block contacting said semiconductor chips and said heat conductive housing and carrying out the transmission of heat therebetween, and a seal housing with which said semiconductor chips, said heat conductive block and said heat conductive housing are sealed.

19. A semiconductor-mounted module comprising a plurality of semiconductors, a heat conductive housing which has a projecting portion a vertical section of which is triangular, and which is provided in said projecting portion with a cooling medium ejecting nozzle, and a heat conductive block slidably contacting said semiconductor chips and said heat conductive housing and carrying out the transmission of the heat occurring in said semiconductor chips.

20. A semiconductor-mounted module comprising a plurality of semiconductor chips, a heat conductive housing which has a projecting portion a vertical section of which is triangular, and which is provided in said projecting portion with a flow passage for a cooling medium, cross-sectionally fan-shaped columnar heat conductive block members contacting said semiconductor chips and said heat conductive housing, and a seal housing with which said semiconductor chips, said heat conductive disc members and said heat conductive housing are sealed.

FIG. 1

FIG. 2

FIG. 3

(a)

(b)

FIG. 4

FIG. 5

FIG. 6

WATER

HEAT TRANSFER PATH

EP 0 375 777 A1

FIG. 7

## *FIG.* 8

## *FIG.* 9

## FIG. 10

## FIG. 11

## FIG. 12

## FIG. 13

## FIG. 14

## FIG. 15

# FIG. 16

# INTERNATIONAL SEARCH REPORT

International Application No  PCT/JP88/00544

**I. CLASSIFICATION OF SUBJECT MATTER** (if several classification symbols apply, indicate all)

According to International Patent Classification (IPC) or to both National Classification and IPC

Int.Cl$^4$    H01L23/36, H01L23/46

**II. FIELDS SEARCHED**

| Minimum Documentation Searched [7] | |
|---|---|
| Classification System | Classification Symbols |
| IPC | H01L23/36, H01L23/46 |

Documentation Searched other than Minimum Documentation
to the Extent that such Documents are Included in the Fields Searched [8]

| | |
|---|---|
| Jitsuyo Shinan Koho | 1970 – 1987 |
| Kokai Jitsuyo Shinan Koho | 1970 – 1987 |

**III. DOCUMENTS CONSIDERED TO BE RELEVANT [9]**

| Category * | Citation of Document, [11] with indication, where appropriate, of the relevant passages [12] | Relevant to Claim No. [13] |
|---|---|---|
| A | JP, A, 52-53547 (IBM) 30 April 1977 (30. 04. 77) US, A, 3993123, DE, A1, 2647758, FR, A1, 2330148 & GB, A, 1521159 | 1-20 |
| A | JP, A, 54-44479 (IBM) 7 April 1979 (07. 04. 79) US, A, 4138692, EP, A1, 1123 & CA, A1, 1097788 | 1-20 |
| A | JP, U, 60-68657 (Fujitsu Ltd.) 15 May 1985 (15. 05. 85) (Family: none) | 1-20 |
| A | JP, A, 61-220359 (Hitachi, Ltd.) 30 September 1986 (30. 09. 86) (Family: none) | 1-20 |

* Special categories of cited documents: [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search | Date of Mailing of this International Search Report |
|---|---|
| August 10, 1988 (10. 08. 88) | August 22, 1988 (22. 08. 88) |
| International Searching Authority | Signature of Authorized Officer |
| Japanese Patent Office | |

Form PCT/ISA/210 (second sheet) (January 1985)